# EUROPÄISCHE PATENTSCHRIFT

(11) **EP 0 885 402 B1**
(45) Veröffentlichungstag und Bekanntmachung des Hinweises auf die Patenterteilung: **28.11.2001**
(21) Anmeldenummer: 97906812.9
(22) Anmeldetag: 03.03.1997
(51) Int. Cl.: G02F 1/29, G02F 1/19

(54) **OPTISCHE MEHRWEGE-WEICHE AUS ELEKTRISCH EINSTELLBAREN PHOTONEN-KRISTALLEN**
OPTICAL MULTI-CHANNEL SEPARATING FILTER WITH ELECTRICALLY ADJUSTABLE PHOTON CRYSTALS
FILTRE DE SEPARATION OPTIQUE A VOIES MULTIPLES AVEC CRISTAUX PHOTONIQUES ELECTRIQUEMENT AJUSTABLES

(30) Priorität: 05.03.1996 DE 19610656
(43) Veröffentlichungstag der Anmeldung: 23.12.1998
(73) Patentinhaber: Deutsche Telekom AG, 53113 Bonn (DE)
(72) Erfinder: KOOPS, Hans, Wilfried, Peter, D-64372 Ober-Ramstadt (DE)
(86) Internationale Anmeldenummer: EP9701064
(87) Internationale Veröffentlichungsnummer: WO9733192

(56) Entgegenhaltungen:
- APPLIED PHYSICS LETTERS, Bd. 67, Nr. 15, 9.Oktober 1995, Seiten 2138-2140, XP000578479 BROWN E R ET AL: "LARGE ELECTROMAGNETIC STOP BANDS IN METALLODIELECTRIC PHOTONIC CRYSTALS"
- PHYSICS AND SIMULATION OF OPTOELECTRONIC DEVICES IV, SAN JOSE, CA, USA, 29 JAN.-2 FEB. 1996, Bd. 2693, ISSN 0277-786X, PROCEEDINGS OF THE SPIE - THE INTERNATIONAL SOCIETY FOR OPTICAL ENGINEERING, 1996, SPIE-INT. SOC. OPT. ENG, USA, Seiten 170-175, XP000671668 LIN S -Y ET AL: "High-Q photonic bandgap resonant cavities: from mm-wave to optical regime"
- PROCEEDINGS OF THE SPIE, Bd. 2849, 5.August 1996, Seiten 248-256, XP000617864 KOOPS H W P: "PHOTONIC CRYSTALS BUILT BY THREE-DIMENSIONAL ADDITIVE LITHOGRAPHY ENABLE INTEGRATED OPTICS OF HIGH DENSITY"

## Beschreibung

Die erfindungsgemäße Lösung beinhaltet eine optische Mehrwege-Weiche aus elektrisch einstellbaren Photonen-Kristallen.
Photonen-Kristalle mit Bandlücken sind bekannt als 2- und 3-dimensionale dielektrische Strukturen, in denen die Ausbreitung elektromagnetischer Wellen, abhängig oder unabhängig von ihrer Ausbreitungsrichtung, verboten ist. Siehe :
1.] John, "Strong Localization of Photons in Certain Disordered Dielectric Superlattices", Phys. Rev. Lett. 58, 2486 (1987)
2.] Yablonovitch, "Inhibited Spontaneous Emission in Solid-state Physics and Electronics", Phys. Rev. Lett. 58, 2059 (1987)
3.]L. McCall, P. m: Platzmann, R. Dalichaouch, D. Smith, S. Schulz, "Microwave Propagation in Two-dimensional Dielectric Lattices", Phys. Rev. Lett. 67. 2017 (1991)
4.]M. Leung, Y. F. Liu, "Full Vector Wave Calculation of Photonic Band Structures in Face-centered-cubic Dielectric Media", Phys. Rev. Lett. 65, 2646 (1990)
5.]L. Mc Call, A. F. J. Levi, R. E. Slusher, S. J. Pearton, R. A. Logan, "Whispering-Gallery Mode Microdisk Lasers", Appl. Phys. Lett. 60, 289 (1992)
6.]Yablonovitch, T. M. Gmitter, "Photonic Band Structure : The Face-centered-cubic Case", Phys. Rev. Lett. 63, 1950 (1989)
7.]Yablonovitch, T. M-. Gmitter, K. M. Leung, "Photonic Band Structure : The Face-centered-cubic Case Employing Nonspherical Atoms", Phys. Rev. Lett. 67, 2295 (1991)
8.]K.M. Ho, C. T. Chan, C. M. Soukoulis, "Existence of a Photonic Gap in Periodic Dielectric Structures", Phys. Rev. Lett. 65, 3152 (1990)

Rechnungen und Mikrowellen-Messungen zeigten, daß eine kubisch flächenzentrierte oder auch eine 2-dimensional kubische Anordnung von Löchern in einer dielektrischen Matrix oder von dielektrischen Stangen solch photonische Bandlücken aufzeigen.
Siehe:
9] S. Y. Lin, A. Arjavalingam "Photonic bound states in two-dimensional photonic Crystals probed by coherenmicrowave transient spectroscopy", J. Opt. Soc. Am. B/Vol. 11. No 10 (1994) 2124
10] S. Y. Lin, G. Arjavalingam, "Tunneling of electro magneticwaves in two-dimensional photonic crystals", Optics Letters Vol. 18, No 19, (1993) 666
11] D. R. Smith, S. Schulz, S. L. McCall, P. M. Platz mann, "Defect studies in a two-do-dimensional periodic photonic lattice". Journal of Modern Optics Vol. 41, 2 (1994) 395
12] C. C. Cheng, A. Scherer, "Fabrication of Photonic Bandgap crystals", J. Vac. Sci. Technol (1995) nov/ dec om Druck

Dabei reichen bereits 6 Ebenen aus, um eine hohe Güte der Elemente zu erzielen [9]. Derartige 2- und 3-dimensionale Strukturen werden häufig "Photonische Kristalle" genannt [2]. Diese Strukturen können wie bekannt mit hoher Präzision durch die Nanolithographie mit elektronenstrahlinduzierter Deposition hergestellt werden.

Füllt man die photonischen Kristalle in ihren Zwischenräumen mit nichtlinear-optischen Materialien oder mit Flüssigkristallen und bringt die gesamte Struktur in ein starkes elektrisches Feld, so kann im Kristall die optisch wirksame Gitterkonstante durch die Veränderung des optischen Weges in Grenzen eingestellt und damit die Filterwirkung des Elementes elektrisch variiert werden. Ebenso ist eine Herstellungsmethode mit dem erweiterten Silylierungsprozeß mit Trockenätzen und Eindiffusion und nachträglicher Füllung der Elemente bekannt, mit der derartige Baugruppen hochintegriert und kostengünstig hergestellt werden können.
Abstimmbare Filter für die optische Nachrichtentechnik und Telekommunikation werden z. Z. in Form von langen optischen Fasern, die ihre Filterwirkung durch mit UV-Licht in spezielle Fasern eingeschriebene Bragg-Beugungsgitter erhalten, realisiert.
13] R. Kashyap, "Photosensitive Optical Fibers: Devices and Applications", Opt. Fibres Techn. 1, 17 - 34, (1994)
14] C. Cremer, H. Heise, R. März, M. Schienle, G. Schulte-Roth, H. Unzeitig, "Bragg Gratings on In GaAsP/InP-Waveguides as Polarization Independent Optical Filters" J. of Lightwave Techn., 7, 11, 164 (1989)
15] R. C. Alferness, L.L. Buhll, U. Koren, B. J. Miller, M. G. Young, T. L. Koch, C. A. Burrus, G. Raybon, "Broadly tunable InGaAsP/InP buried rib waveguide vertical coupler filter", Appl. Phys. Lett. 60, 8, 980 (1992)
16] C. Wu, C. Rolland, F. Sheperd, C. Laroque, N. Puetz, K. D. Chik, J. M. Xu, "InGaAsP/InP Vertical Coupler Filter with Optimally Designed Wavelength Tunability", IEEE Photonics Technol. 4, 4, 457 (1993)
17] Z. M. Chuang, L. A. Coldren "Enhanced wavelength tuning in gratin assisted codirectional coupler filter", IEEE Photonics Technology Lett., 5, 10, 1219 (1993)

Dabei stellt es eine beträchtliche technologische Anforderung dar, diese Beugungsgitter mit hoher Genauigkeit über große Längen von einigen mm bis cm herzustellen. Spezielle die Elektronenstrahl-Lithographie in ihrem "Stitching" verbessernde Verfahren werden angewandt, um diesen Fehler zu verringern.
18] H. W. P. Koops, J. Kretz, M. Weber, "Combined Lithographies for the reduction of stitching errors in Lithography", Proc EIPB 94, J. Vac. Sci Technol B 12 (6) (1994) 3265-3269
19] B. H. Koek, T. Chisholm, A. J. van Run, J. Romijn, Sub 20 nm stitching and overlay for nanolithography Applications, Jpn. J. Appl. Phys. Vol. 33 (1994) xxx
20] V. V. Wong, J. R. Ferrera, N. J. Damask, H. I. Smith, Fabrication and Measurement of Highly Coherent Electron-Beam-Written Bragg Resonators, Abstracts EIPB'95 Scottsdale N3, 331 (1995)

Faserfilter und Faserkoppler müssen immer mit Steckern oder Spleissen in einer Hybridtechnik in eine makroskopische optische Anordnung eingefügt werden. Eine Miniaturisierung der Baugruppen ist damit nicht zu erreichen.
Mit dem Verfahren der Additiven Lithographie durch rechnergeführte elektronenstrahlinduzierte Deposition werden Photonen-Kristalle aus 2- und 3-dimensionalen Anordnungen von langen miniaturisierten Nadeln aus dielektrischen Materialien mit Nanometer-Präzision miniaturisiert aufgebaut
21] H. W. P. Koops, R. Weiel, D. P. Kern, T. H. Baum, "High Resolution Electron Beam Induced Deposition", Proc. 31. Int. Symp. on Electron, Ion, and Photon Beams, J. Vac. Sci. Technol. B (1) (1988) 477

Diese können direkt in den optischen Weg eingebaut werden. Durch die bei dem Verfahren übliche hochpräzise Rechnersteuerung des Elektronenstrahles in Ort, Zeit und Bewegungsrichtung ist es möglich, nahezu alle geforderten Geometrien der Kristalle und ihre für den gewünschten optischen Zweck gezielten Deformationen zu erzeugen. Dadurch kann ein maßgeschneidertes optisches Verhalten der Struktur erzeugt werden. Durch Füllen der hochbrechenden Nadelstrukturen mit nichtlinear-optischem Material, siehe
22] M. Eich, H. Looser, D. Y. Yoon, R. Twieg, G. C. Bjôrklund, "Second harmonic generation in poled organic monomeric glasses", J. Opt. Soc. Am. B, 6, 8 (1989),
23] M. Eich, A. Sen, H. Looser, G. C. Björklund, J. D. Swalen, R. Twieg, D. Y. Yoon, "Corona Poling and Real Time Second Harmonic Generation Study of a Novel Covalently Functionaliced Amorphous Nonlinear Polymer", J. Appl. Phys. 66, 6 (1989),
24] M. Eich, G. C. Bjôrklund, D. Y. Yoon, "Poled Amorphous Polymers of Second Order Nonlinear Optics", Polymers for Advanced Technologies, 1, 89 (1990),
oder durch Füllen der hochbrechenden Nadelstrukturen mit Flüssigkristallen, siehe
25] R. Birenheide, M. Eich, D. A. Jungbauer, O. Herrmann-Schönherr, K. Stoll, J. H. Wendorff, "Analysis of Reorientational Processes in Liquid Crystalline Side Chain Polymers Using Dielectric Relaxation, Electro-Optical Relaxation and Switching Studies", Mol. Cryst. Liq. Cryst., 177, 13 (1989)
und durch Anlegen eines starken elektrischen Feldes an die gefüllte Struktur kann der optische Weg im Kristall und damit dessen Eigenschaften elektrisch eingestellt werden. Damit ist die optische Durchlaßcharakteristik fein verschiebbar, die optische Spiegelwirkung variierbar und die Reflexionsrichtung und eventuell die Stärke variierbar. Da das Element sehr hohe Güte besitzt und dabei sehr klein ist (die Abmessungen betragen wenige um in Länge, Breite und Höhe), können mit derartigen Filtern und Spiegeln ausgestattete optische Elemente und Schaltungen in hoher Packungsdichte hergestellt werden 1.
Desweiteren sind Lösungen bekannt, die auf Vielstrahl-Schreibgeräten mit Korpuskularstrahlen basieren. Mittels dieser Methode können optoelektronische Elemente und integrierte optische Schaltungen in wirtschaftlicher Weise mit Hilfe der Additiven Lithographie gefertigt werden. Siehe:
26] H. Koops, 1974, Deutsches Patent angem. P 2446 789.8-33 "Korpuskularstrahloptisches Gerät zur Korpuskelbestrahlung eines Präparates", USA-Patent erteilt: No. 4021674, 4. 05. 1977,
27] H. Koops, 1974, Deutsches Patent angem. P 2460 716.7 "Korpuskularstrahloptisches Gerät zur Korpuskelbestrahlung eines Präparates, deutsches Patent erteilt: 30. 12. 1976,
28] H. Koops, 1974, Deutsches Patent angem. P 2460 715.6 "Korpuskularoptisches Gerät zur Korpuskelbestrahlung eines Präparates in Form eines Flächenmusters mit mehreren untereinander gleichen Flächenelementen", deutsches Patent erteilt 31. 10. 1979,
29] H. Koops, 1975, Deutsches Patent angem. P 2515 550.4 "Korpuskularoptisches Gerät zur Abbildung einer Maske auf ein zu bestrahlendes Präparat", deutsches Patent erteilt 18. 05. 1977,
30] M. Rüb, H. W. P. Koops, T. Tschudi "Electron beam induced deposition in a reducing image projector", Microelectronic Engineering 9 (1989) 251-254 und
31] H. Elsner, H.-J. Döring, H. Schacke, G. Dahm, H. W. P. Koops, "Advanced Multiple Beam-shaping Diaphragm for Efficient Exposure", Microelectronic Engineering 23 (1994) 85-88.

Ziel der Erfindung ist eine verlustarme Weichen-Anordnung, die auf elektrisch einstellbaren Photonen-Kristallen basiert und damit eine hohe Packungsdichte garantiert.

Dieses Ziel wird durch die in Anspruch 1 definierte optische Mehrwege-Weiche erreicht, bei der ein 2- oder 3-dimensionaler Photonen-Kristall aus hochbrechendem dielektrischen Material mit Hilfe der elektronenstrahlinduzierten Deposition oder mit Nanolithographie hergestellt wird. Weitere Ausführungsformen sind in den abhängigen Ansprüche spezifiziert. Photonen-Kristalle sind 3-dimensionale dielektrische Strukturen, in welchen elektromagnetische Wellen eines bestimmten Wellenlängenbereiches verboten sind, unabhängig von ihrer Ausbreitungsrichtung. Solche Photonen-Kristalle mit Bandlücken und je nach Ausführung einem oder mehreren schmalbandigen Durchlaßbereichen wirken als schmalbandige Filter. Berechnungen und Mikrowellen-Messungen zeigten, daß eine kubisch flächenzentrierte oder auch eine 2-dimensional kubische Anordnung von Löchern in einer dielektrischen Matrix oder von dielektrischen Stangen solch photonische Bandlücken aufzeigen. Dabei reichen bereits 6 Ebenen aus, um ein Element hoher Güte zu erzielen.

Mit dem Verfahren der Additiven Lithographie werden 2- und 3-dimensionale Anordnungen von langen miniaturisierten Nadeln aus dielektrischen Materialien mit Nanometer-Präzision direkt im optischen Weg aufgebaut. Durch die bei dem Verfahren übliche hochpräzise Rechnersteuerung des Elektronenstrahles in Ort, Zeit und Bewegungsrichtung ist es möglich, nahezu alle geforderten Geometrien der Kristalle und ihre für den gewünschten optischen Zweck gezielten Deformationen zu erzeugen. Dadurch kann ein maßgeschneidertes festes optisches Verhalten der Struktur erzeugt werden. Ähnliche Strukturen können auch durch Nanolithographische Verfahren und den erweiterten Prozeß der Silylierung mit Trockenätzen hergestellt werden.

Durch Füllen der Nadelzwischenräume mit nichtlinear-optischen Materialien und durch Anordnung des Kristalles im elektrischen Feld kann die Anordnung in einem bestimmten Wellenlängenbereich elektrisch abgestimmt und mit hoher Präzision eingestellt werden. Durch die Verwendung von Flüssigkristall-Materialien zur Füllung der Struktur ist eine im weiten Bereich mögliche Einstellbarkeit des Filters erreichbar. Durch die Verwendung von Flüssigkristallen als Füllmaterial kann der Filter als Schalter mittlerer Schnelligkeit eingesetzt werden. Damit kann mit einem mit nichtlinearem Material gefüllten Kristall ein schaltbarer Spiegel realisiert werden.

Die erfindungsgemäße Weiche wird aus einstellbaren Photonen-Kristallen realisiert. Diese Photonen-Kristalle bestehen aus langen miniaturisierten Nadeln, die als hochpräzise optische Spiegel wirken. Aus diesen Nadeln wird eine optische Struktur erzeugt, in der als photonische Bandlücken wirkende Deformationen gezielt eingebracht sind.

Die Nadelzwischenräume sind mit nichtlinear optischen Materialien bzw. Flüssigkristallen gefüllt. Durch die Anordnung von Elektroden an die optische Struktur und damit durch Anlegen eines starken elektrischen Feldes läßt sich die optische Durchlaßcharakteristik der gesamten optischen Struktur bis zur Reflexion verändern. Durch die Anordnung von weiteren unterteilten Elektroden zur separaten Feldführung in einzelnen Kristallbereichen der optischen Struktur wird erreicht, daß die optische Struktur gleichzeitig in ihrer optischen Durchlaßcharakteristik in einzelnen Kristall-Bereichen getrennt bis zur Reflexion veränderbar ist. Zu den einzelnen Richtungsbereichen der optischen Struktur sind feststehende Photonenspiegel winklig direkt im optischen Weg angeordnet, so daß das Licht über die feststehenden Photonenspiegel ein- und ausgekoppelt werden kann.
Damit wird über die Veränderung der Durchlaßcharakteristik der optischen Struktur in Verbindung mit der gezielten Auskopplung des Lichtes über die einzelnen feststehenden Photonenspiegel die Funktion einer optischen Weiche realisiert.

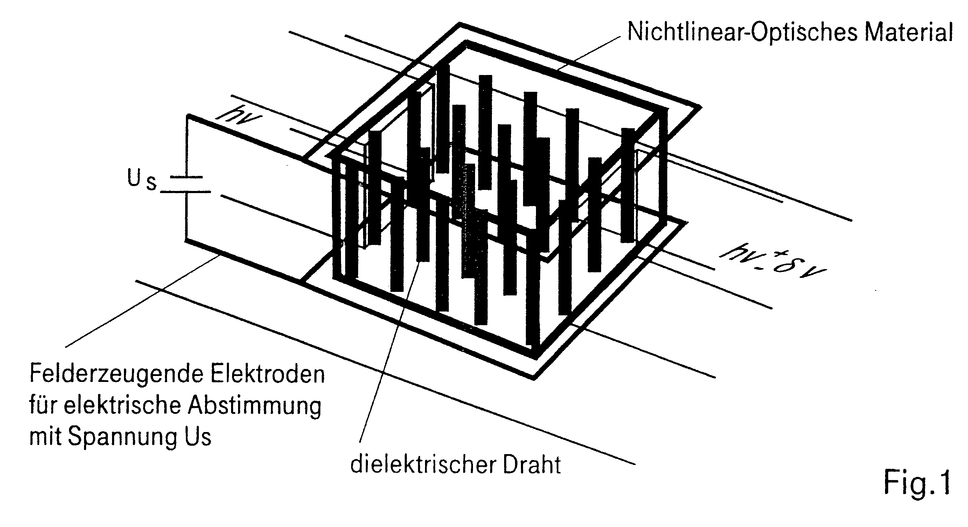

In Figur 1 ist das Schema eines abstimmbaren Photonen-Kristalls abgebildet, der als schmalbandiger Filter in einem Monomode-Wellenleiter eingesetzt wird.

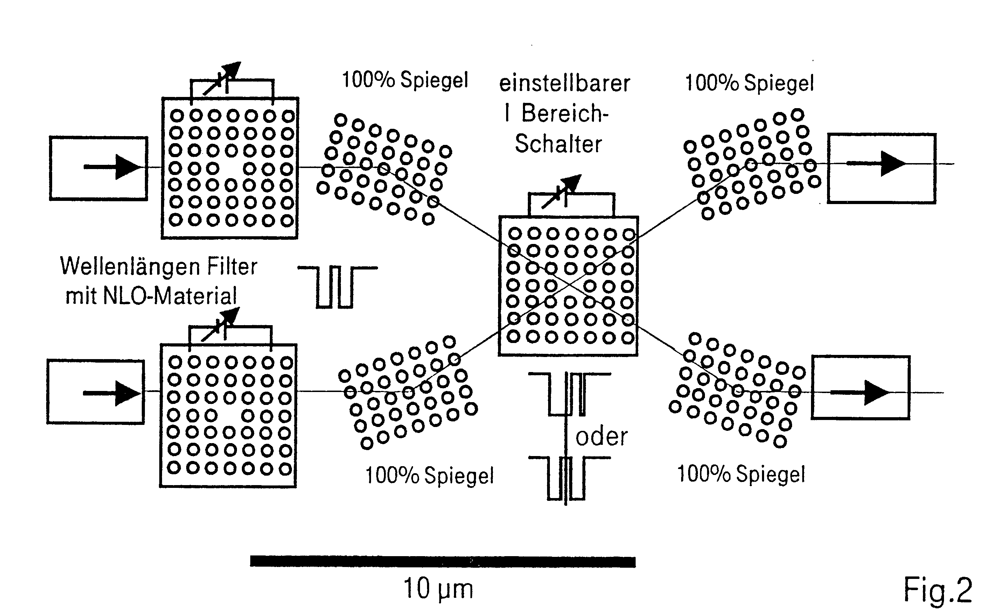

Basierend auf diesem Prinzip kann beispielsweise eine optisch einstellbare verlustarme 2-Wege-Weiche entsprechend Figur 2 aufgebaut werden. Dabei wird im optischen Weg eine als abstimmbarer Spiegel ausgebildete optische Struktur zwischen feststehenden Photonenspiegeln angeordnet. Die feststehenden Photonenspiegel sind so ausgerichtet, daß das Licht unter einem Winkel von 22,5 Grad gespiegelt und damit unter einem Winkel von 45 Grad auf die als abstimmbarer Spiegel ausgebildete Struktur des mit nichtlinearem Material gefüllten Photonen-Kristalls trifft. Wenn die Geometrie des als abstimmbarer Spiegel wirkenden Photonen-Kristalls in Durchlaßrichtung geschaltet ist, wird das Licht unbeeinflußt durchgelassen. Wenn die Struktur des als abstimmbarer Spiegel wirkenden Photonen-Kristalls in Reflexion geschaltet ist, wird das Licht genau in dem feststehenden Spiegel reflektiert, welcher das Licht in den weiterführenden Wellenleiter einkoppelt.
Derartige Bauelemente finden Einsatz in Netzwerken der Vermittlungstechnik und ermöglichen die Dienste-Selektion. Dabei ist die Packungsdichte mit dieser Technik stark erhöht, denn die Baugruppe aus Spiegeln und Filterschalter hat weniger als 12 µm in Längen- und Breitenabmessung.

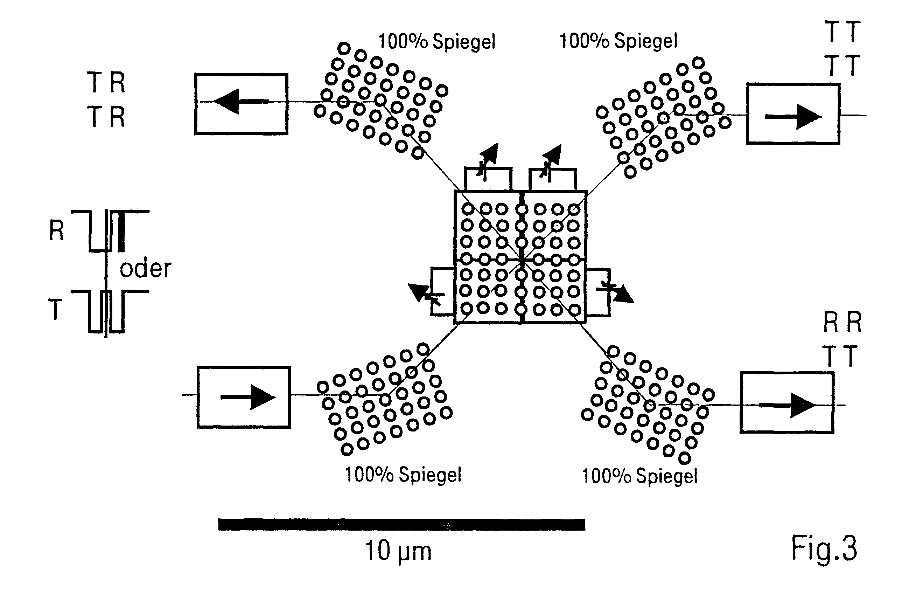

Strukturiert man die Feldplatten im Bereich des Kristalls in 4 Teile, so kann durch wahlweise Schaltung der 4 Kristall-Quadranten eine Transmission und eine Reflexion in je einer Hälfte eingestellt werden. Damit ist eine 3-Wege-Weiche nach Figur 3 mit einem Element mit um 90 Grad gegeneinander orientierten Strahlwegen realisierbar.

Durch gezieltes Einstellen der Transmission und Reflexion in Kristallbereichen zwischen feiner strukturierten Feld-Platten kann außer der Einstellung der Reflexion und Transmission auch der Strahl in seiner Intensität elektrisch gesteuert aufgeteilt werden.

Eine weitere Möglichkeit die elektrische Einstellung der Weiche zu beeinflussen besteht darin, durch eine steuerbare auf den mit nichtlinear-optischem Material gefüllten Photonen-Kristall gerichtete Lichtquelle zusätzlich geführtes Licht in den Photonen-Kristall einzukoppeln. Damit wird schnelles Schalten im oberen Gigahertz-Bereich möglich. Das Licht kann dabei auch auf die Ebene der Wellenleiter-Lichtführung aus dem Raum darüber oder darunter gerichtet sein. Das ermöglicht die in Ebenen getrennte Führung von Schalt-Licht und zu schaltendem Licht.

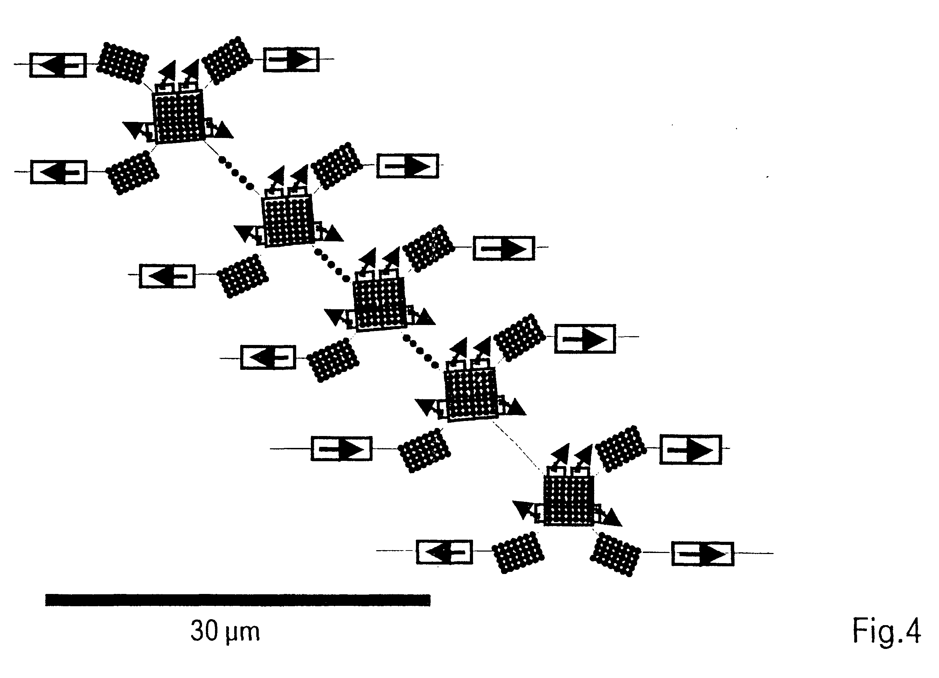

Figur 4 zeigt das Schema einer elektrisch einstellbaren Mehrwege-Weiche die aus mehreren 3-Wege-Weichen aus elektrisch getrennt abstimmbaren Photonen-Kristall-Bereichen und Umlenkspiegeln aus Photonen-Kristallen aufgebaut ist. Diese Anordnung stellt somit einen kaskadierten Koppler-Schalter aus miniaturisierten schaltbaren 4-Wege Richtkopplern aus Photonen-Kristallen mit einstellbarem Band-Pass dar.

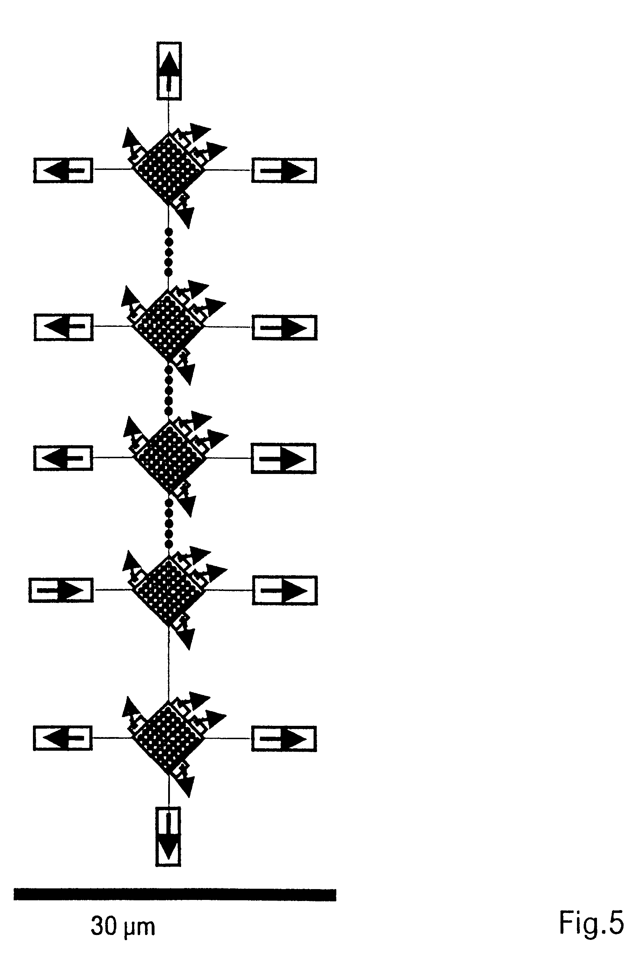

In Figur 5 ist das Schema einer elektrisch einstellbaren Mehrwege-Weiche dargestellt. Die Mehrwege-Weiche ist aus mehreren 3-Wege-Weichen aus elektrisch getrennt abstimmbaren Photonen-Kristall-Bereichen aufgebaut und stellt somit einen kaskadierten Koppler-Schalter aus miniaturisierten schaltbaren 4-Wege-Richtkopplern mit einstellbarem Band-Pass dar.

Mit derartigen Bauelementen können in Kombination mit anderen gleichartigen oder auch andersartigen integrierten Bauelementen, wie Spiegeln, Phasenschiebern und Reflektoren integrierte Schaltungen zur optischen Signalverarbeitung und zu optischen Rechnern mit hoher Packungsdichte aufgebaut werden. Ebenso ist die Realisierung festeingestellter oder auch variabler Meßschaltungen für Sicherheitsaufgaben und Prüfverfahren für die Datenkommunikation auf Glasfasern möglich.

Die erfindungsgemäße Lösung stellt eine neuartige schaltbare Weichen-Anordnung dar, die in integrierter Technik mit hoher Packungsdichte eingesetzt werden kann und das Schalten mit Spannungen und/oder mit Licht zwischen mindestens zwei optischen Wegen, sowie deren Überkreuzung ermöglicht. Durch die Integration entfällt der Platzbedarf für Stecker zum Einfügen des Elementes in die optischen Wege beispielsweise einer Rechnerschaltung.

## Patentansprüche

1. Optische Mehrwege-Weiche mit einer optischen Struktur, die aus elektrisch einstellbaren Photonen-Kristallen, die aus langen miniaturisierten Nadeln gebildet sind, und die als hochpräzise optische Spiegel wirken, aufgebaut ist, wobei in der optischen Struktur als photonische Bandlücken wirkende Deformationen gezielt eingebracht sind, wobei die Nadelzwischenräume mit nichtlinear optischen Materialien bzw. Flüssigkristallen gefüllt sind und Elektroden derart an der optischen Struktur angeordnet sind, daß durch Anlegen eines starken elektrischen Feldes die optische Durchlaßcharakteristik der gesamten optischen Struktur bis zur Reflexion veränderbar ist, wobei die optische Struktur mit weiteren unterteilten Elektroden zur separaten Feldführung in Kristallbereichen versehen ist, so daß die optische Struktur gleichzeitig in ihrer optischen Durchlaßcharakteristik in einzelnen Kristallbereichen getrennt bis zur Reflexion veränderbar ist, wobei die optische Struktur zwischen Spiegeln aus feststehenden Photonen-Kristallen angeordnet und derart ausgerichtet ist, daß Licht unter einem vorbestimmten Winkel auf die optische Struktur trifft, wobei das Licht über die Spiegel aus feststehenden Photonen-Kristallen ein- und ausgekoppelt wird, so daß über die Veränderung der Durchlaßcharakteristik der optischen Geometrie und damit die Möglichkeit der gezielten Auskopplung des Lichtes über die einzelnen Spiegel aus feststehenden Photonen-Kristallen eine Weichenfunktion erzielt wird.

2. Optische Mehrwege-Weiche nach Anspruch 1, **dadurch gekennzeichnet, daß** im optischen Weg eine als abstimmbarer Spiegel ausgebildete optische Struktur zwischen den Spiegeln aus feststehenden Photonen-Kristallen angeordnet ist, wobei die Spiegel aus feststehenden Photonen-Kristallen so ausgerichtet sind, daß das Licht unter einem Winkel von 22,5 Grad gespiegelt und damit unter einem Winkel von 45 Grad auf die als abstimmmbarer Spiegel ausgebildete Struktur des mit nichtlinearen Material gefüllten Photonen-Kristalls trifft, und daß die Struktur des als abstimmbarer Spiegel wirkenden Photonen-Kristalls in Durchlaßrichtung geschaltet das Licht unbeeinflußt durchläßt und in Reflexion geschaltet das Licht genau in dem feststehenden Spiegel reflektiert, welcher das Licht in einen weiterführenden Wellenleiter einkoppelt, so daß eine 2-Wege-Weiche mit Strahl-Überkreuzungsmöglichkeit entsteht.

3. Optische Mehrwege-Weiche nach Anspruch 1, **dadurch gekennzeichnet, daß** der als Weiche mit nichtlinear-optischem Material gefüllte Photonen-Kristall zwischen elektrischen Feldplatten angeordnet ist, daß die Feldplatten in vier Quadranten aufgetrennt angeordnet sind, daß die elektrischen Felder in den einzelnen Quadranten einzeln so einstellbar sind, daß einzelne Teilkristalle in Transmission oder in Reflexion schaltbar sind, so daß Photonen-Kristall einen einfallenden Lichtstrahl wahlweise unbeeinflußt durchlassen oder in eine von zwei vorbestimmten Richtungen reflektieren kann, wodurch die Funktion einer elektrisch einstellbaren 3-Wege-Weiche realisiert wird.

4. Optische Mehrwege-Weiche nach Anspruch 1, **dadurch gekennzeichnet, daß** ein in mehrere Bereiche geteilter Photonen-Kristall verwendet wird, um Licht entweder aus einer Richtung in weiterführende Richtungen zu lenken oder auf einen benachbart angeordneten gleichartigen steuerbaren Kristall zu richten, so daß eine Verzweigung in weitere Richtungen erreicht wird, wodurch eine kaskadierbare Vermittlungsstruktur in dekadischer oder anderer modularer Anordnung realisiert wird.

5. Optische Mehrwege-Weiche nach Anspruch 1, **dadurch gekennzeichnet, daß** die elektrisch einstellbaren Photonen-Kristalle ihr Licht auf Spiegel aus Photonenkristallen lenken, welche die Orientierung unter 45 Grad in ein rechtwinkliges Muster ausrichten, so daß eine geometrische Einpassung der elektrisch einstellbaren Kristalle bewirkt wird.

6. Optische Mehrwege-Weiche nach Anspruch 1, **dadurch gekennzeichnet, daß** der elektrisch einstellbare Photonen-Kristall durch gezielt angeordnete Deformationen in mehr als vier Bereiche unterteilt ist, so daß eine feinere Aufteilung der stellbaren Kristallbereiche erreicht wird, so daß außer der Richtungsanpassung auch eine Intensitätsanpassung der umgelenkten Lichtstrahlen möglich ist.

7. Optische Mehrwege-Weiche nach Anspruch 1, **dadurch gekennzeichnet, daß** die elektrische Einstellung der Weiche durch eine steuerbare auf den Photonen-Kristall gerichtete Lichtquelle beinflussbar, über die zusätzlich geführtes Licht in den Photonen-Kristall eingekoppelt werden kann.

## Claims

1. Optical multichannel separating filter with an optical structure which is constructed from electrically adjustable photon crystals, which are formed from long miniaturized needles and which act as high-precision optical mirrors, deformations acting in the optical structure as photon band gaps being specifically introduced, the needle interspaces being filled with nonlinearly optical materials or liquid crystals, and electrodes being arranged at the optical structure in such a way that the optical forward characteristic of the entire optical structure can be varied up to reflection by applying a strong electric field, the optical structure being provided with further subdivided electrodes for separate field guidance in crystal regions such that the optical structure can simultaneously have its optical forward characteristic varied in individual crystal regions separately up to reflection, the optical structure being arranged between mirrors made from fixed photon crystals and being aligned in such a way that light strikes the optical structure at a predetermined angle, the light being coupled into and out of fixed photon crystals via the mirrors, such that a filter function is achieved via the variation in the forward characteristic of the optical geometry, and thereby the possibility of coupling of the light specifically via the individual mirrors made from fixed photon crystals.

2. Optical multichannel separating filter according to Claim 1, **characterized in that** an optical structure designed as a tuneable mirror is arranged in the optical path between the mirrors made from fixed photon crystals, the mirrors made from fixed photon crystals being aligned such that the light is reflected at an angle of 22.5 degrees and thus strikes the structure, designed as a tuneable mirror, of the photon crystal filled with nonlinear material at an angle of 45 degrees, and **in that** the structure of the photon crystal, acting as a tuneable mirror, passes the light without influencing it when switched in the forward direction and, when switched to reflection, reflects the light precisely into the fixed mirror which couples the light into an onward-going waveguide such that a 2-channel separating filter with the possibility of crossover is produced.

3. Optical multichannel separating filter according to Claim 1, **characterized in that** the photon crystal filled as separating filter with nonlinear-optical material is arranged between electric field plates, **in that** the field plates are arranged separately in four quadrants, and **in that** the electric fields in the individual quadrants can be adjusted individually such that individual subcrystals can be switched to transmission or to reflection such that the photon crystal can optionally pass an incident light beam without influencing it or can reflect it in one of two predetermined directions, the function of an electrically adjustable 3-channel separating filter being realized as a result.

4. Optical multichannel separating filter according to Claim 1, **characterized in that** use is made of a photon crystal divided into a plurality of regions in order either to direct light from one direction into onward-going directions, or to direct it to a similar controllable crystal arranged adjacently, such that branching into further directions is achieved, thus implementing a cascadeable switching structure in the decimal or other modular arrangement.

5. Optical multichannel separating filter according to Claim 1, **characterized in that** the electrically adjustable photon crystals direct their light to mirrors made from photon crystals, which align the orientation at 45 degrees into a rectangular pattern such that a geometrical adaptation of the electrically adjustable crystals is effected.

6. Optical multichannel separating filter according to Claim 1, **characterized in that** the electrically adjustable photon crystal is subdivided into more than four regions by specifically arranged deformations such that a finer division of the controllable crystal regions is achieved and so an adaptation of the intensity of the deflected light beams is also possible in addition to the adaptation of direction.

7. Optical multichannel separating filter according to Claim 1, **characterized in that** the electrical adjustment of the separating filter can be influenced by a controllable light source directed onto the photon crystal and via which light additionally supplied can be coupled into the photon crystal.

## Revendications

1. Séparateur optique multivoies comprenant une structure optique constituée de cristaux photoniques à réglage électrique qui sont formés de longues aiguilles miniaturisées et qui agissent comme des miroirs optiques de haute précision, des déformations agissant comme des écarts de bande photoniques étant intégrés de manière ciblée dans la structure optique, les espaces entre les aiguilles étant remplies de matériaux optiques ou de cristaux liquides non linéaires et des électrodes étant disposées sur la structure optique de manière à pouvoir modifier la caractéristique de transparence de l'ensemble de la structure optique jusqu'à la réflexion en appliquant un champ électrique puissant, la structure optique étant munie d'électrodes subdivisées supplémentaires pour guider séparément le champ dans les zones des cristaux de manière à ce que la caractéristique de transparence de la structure optique puisse en même temps être modifiée séparément jusqu'à la réflexion dans chacune des zones des cristaux, la structure optique étant disposée entre des miroirs de cristaux photoniques fixes et alignée de manière à ce que la lumière rencontre la structure optique sous un angle donné, la lumière pénétrant et sortant par le biais des miroirs en cristaux photoniques fixes de manière à ce que la modification de la caractéristique de transparence de la forme géométrique optique et, de ce fait, la possibilité de faire sortir la lumière de manière ciblée par le biais de chacun des miroirs en cristaux photoniques fixes produise une fonction de séparateur.

2. Séparateur optique multivoies selon la revendication 1, **caractérisé en ce que** qu'une structure optique configurée sous la forme d'un miroir accordable est disposée dans le trajet optique entre les miroirs en cristaux photoniques fixes de manière à ce que la lumière soit réfléchie sous un angle de 22,5 degrés et parvienne ainsi sous un angle de 45 degrés sur la structure réalisée sous la forme d'un miroir accordable du cristal photonique rempli de matériau non linéaire et que la structure du cristal photonique faisant office de miroir accordable laisse passer la lumière sans l'affecter lorsqu'elle est commutée dans le sens du passage et, lorsqu'elle est commutée en réflexion, réfléchisse la lumière exactement dans le miroir fixe qui laisser entrer la lumière dans un guide d'onde prolongateur de manière à obtenir un séparateur à 2 voies avec possibilité de convergence des rayons.

3. Séparateur optique multivoies selon la revendication 1, **caractérisé en ce que** le cristal photonique faisant office de séparateur et rempli de matériau optique non linéaire est disposé entre des plaques de champ électrique, que les plaques de champ son disposées séparément dans quatre quadrants, que les champs électriques peuvent être réglés individuellement dans chacun des quadrants de manière à ce que chacun des cristaux partiels puissent être commutés en transmission ou en réflexion de manière à ce que le cristal photonique, au choix, laisse passer un rayon lumineux incident sans l'affecter ou puisse le réfléchir dans l'une des deux directions prédéfinies, ce qui réalise la fonction d'un séparateur à 3 voies à réglage électrique.

4. Séparateur optique multivoies selon la revendication 1, **caractérisé en ce que** le cristal photonique utilisé est divisé en plusieurs zones, soit afin de dévier la lumière en provenance d'une direction vers des directions prolongatrices, soit pour la diriger sur un cristal commandable du même type disposé à côté de manière à obtenir une séparation dans des directions supplémentaires, ce qui permet de réaliser une structure de commutation par décades ou dans un autre arrangement modulaire.

5. Séparateur optique multivoies selon la revendication 1, **caractérisé en ce que** les cristaux photoniques à réglage électrique dévient leur lumière sur des miroirs en cristaux photoniques qui alignent l'orientation sous 45 degrés en un modèle à angle droit de manière à effectuer une adaptation géométrique des cristaux à réglage électrique.

6. Séparateur optique multivoies selon la revendication 1, **caractérisé en ce que** le cristal photonique à réglage électrique est subdivisé en plus de quatre zones par des déformations ciblées de manière à obtenir une division plus fine des zones réglables du cristal afin de permettre également une adaptation de l'intensité des rayons lumineux déviés en plus d'une adaptation de leur direction.

7. Séparateur optique multivoies selon la revendication 1, **caractérisé en ce que** le réglage électrique du séparateur peut être influencé par une source de lumière commandable dirigée sur le cristal photonique et par le biais de laquelle de la lumière supplémentaire peut être acheminée dans le cristal photonique.
